# FASCICULE DE BREVET EUROPEEN

(11) **EP 2 551 896 B1**
(45) Date de publication et mention de la délivrance du brevet: **11.03.2015**
(21) Numéro de dépôt: 12177592.8
(22) Date de dépôt: 24.07.2012
(51) Int. Cl.: H01L 21/761, H01L 21/8238, H01L 21/8249

(54) **Substrat semi-conducteur comprenant des zones dopées formant une jonction P-N**
Halbleitersubstrat mit einen p-n Übergang ausbildenden dotierten Gebieten
Semiconductor substrate comprising doped regions forming a p-n junction

(30) Priorité: 25.07.2011 FR 1156772
(43) Date de publication de la demande: 30.01.2013
(73) Titulaire: Altis Semiconductor, 91105 Corbeil Essonnes Cedex (FR)
(72) Inventeur: Kellener, Olivier Philippe, 91100 Corbeil Essonnes (FR); Dubois, Gérard, 77380 Combs la Ville (FR); Kanoun, Mehdi Mohamed, 91510 Janville sur Juine (FR); Mcardle, Stephen, Charlestown, Fife KYII 3EF (GB)
(74) Mandataire: Peguet, Wilfried

(56) Documents cités:
- EP-A2- 0 341 461
- WO-A1-96/32798
- DE-A1-102006 031 538
- JP-A- 2001 345 377
- US-A- 5 237 193
- US-A1- 2008 224 214
- US-B1- 6 191 466
- US-B1- 6 307 232

## Description

La présente invention se rapporte à un substrat semi-conducteur comprenant des zones dopées formant une jonction P-N.

Elle s'applique typiquement, mais non exclusivement, au domaine des substrats semi-conducteurs comprenant une couche enfouie ou enterrée, bien connue sous l'anglicisme « *buried layer* ».

Plus particulièrement, le substrat semi-conducteur fait partie d'un circuit intégré, obtenu par exemple par des technologies biens connues de l'homme du métier telles que par les technologies CMOS (« *Complementary Metal Oxide Semiconductor* »)*,* BICMOS (« *Bipolar-CMOS* ») ou BCD (Bipolar,CMOS,DMOS)

Le document US 2008/0224214 décrit un tel transistor avec une tension de claquage élevée.

Dans ces différents types de technologies, il est courant d'avoir des couches dopées dites enterrées ou *« buried layer »* au sein d'un matériau semi-conducteur, pour assumer différentes fonctions comme un collecteur pour un transistor bipolaire, un drain pour un transistor vertical ou simplement une isolation verticale en profondeur. Les applications de ces couches sont donc multiples et peuvent être par exemple utilisée pour délimiter un puits triple (ou *« triple well »* en anglais), ce dernier correspondant à une zone isolée pouvant recevoir une polarisation particulière. A ce titre, on peut citer le document US 7 008 836 qui décrit la fabrication d'un *« triple well »* dopé P, comme une zone délimitée par deux puits dopé N (ou *« N-well* » en anglais), au sein d'un substrat semi-conducteur de silicium dopé P, ces deux puits dopés N étant reliés en profondeur par une couche dopée N dite enterrée. La face avant du substrat est la face sur laquelle sont positionnés les composants actifs du circuit intégré, tels que des transistors par exemple.

L'un des deux puits dopé N peut être facilement utilisé en partie pour former une jonction P-N, en contact avec la face avant du substrat, avec un élément P adjacent (par exemple un autre puits dopé P). La caractéristique diodique de cette jonction est souvent utilisée pour isoler les 2 puits N et P l'un de l'autre en la polarisant avec un champ électrique inverse. La distance relative entre le puits N et le puits P détermine le champ électrique maximum applicable pour isoler correctement ces 2 éléments.

Le but de la présente invention est de pallier les inconvénients des techniques de l'art antérieur en proposant notamment un substrat semi-conducteur comprenant une jonction P-N destinée à permettre une isolation électrique à plus haute tension, et à limiter de façon significative, voire à éviter, à ce qu'un claquage électrique de ladite jonction P-N puisse endommager des composants actifs situés proche de cette jonction P-N.

La présente invention a pour objet un substrat semi-conducteur selon la revendication 1. Le substrat comprend des zones dopées formant une jonction P-N, les zones dopées comprenant:
- une première zone dopée selon un premier type de dopage,
- une deuxième zone dopée selon un deuxième type de dopage, et
- une troisième zone dopée selon le deuxième type de dopage, la troisième zone étant située entre la première zone et la deuxième zone, la concentration en élément dopant de la troisième zone étant inférieure à la concentration en élément dopant de la première zone et inférieure à la concentration en élément dopant de la deuxième zone,
le substrat étant caractérisé en ce que la jonction P-N comprend en outre une quatrième zone dopée comportant :
- une première portion (directement) en contact avec la première zone, et
- une deuxième portion (directement) en contact avec la troisième zone, ladite deuxième portion s'étendant en direction de la deuxième zone, et n'étant pas (directement) en contact avec la deuxième zone,
ladite quatrième zone étant dopée selon le même type de dopage que celui de la première zone.

Dans la présente invention, le terme « directement » dans l'expression préférée « directement en contact » signifie plus particulièrement « directement en contact physique ».

Le matériau utilisé pour la fabrication du substrat semi-conducteur dans le cadre de la présente invention est de préférence du silicium. Par conséquent, les différentes zones dopées constitutives du substrat sont en matériau silicium dopé.

La quatrième zone permet d'éloigner, ou « d'enterrer », un claquage électrique de la jonction P-N, ce qui a l'avantage d'éviter d'endommager les composants actifs positionnés sur la face supérieure du substrat, lorsque cette jonction P-N se trouve à proximité de ladite face.

En outre, en optimisant les dimensions de la quatrième zone, notamment la portion de la quatrième zone se trouvant en contact avec la troisième zone, la jonction P-N de l'invention pourra recevoir des tensions plus importantes que celles de l'art antérieur, tout en garantissant des dimensions de la même taille que celles de l'art antérieur, voire même des dimensions inférieures à celles de l'art antérieur.

L'optimisation des dimensions de la quatrième zone pourra se faire facilement en utilisant des techniques de modélisation bien connues de l'homme du métier, telles que par exemple la résolution de l'équation de Poisson par TCAD (*Technology Computer-Aided Design*).

La concentration en élément dopant peut être constante dans une ou plusieurs zones dopées et/ou peut être un gradient de concentrations dans une ou plusieurs zones dopées.

Dans un mode de réalisation particulier, la concentration en élément dopant de la quatrième zone est (strictement) supérieure à la concentration la plus élevée en élément dopant de la première zone.

Dans un autre mode de réalisation particulier, la concentration en éléments dopants de la troisième zone est (strictement) inférieure à la concentration la plus basse en élément dopant de la première zone, est (strictement) inférieure à la concentration la plus basse en élément dopant de la deuxième zone, et est (strictement) inférieure à la concentration la plus basse en élément dopant de la quatrième zone.

A titre d'exemple, en considérant que le matériau utilisé pour la fabrication du substrat semi-conducteur est du silicium:
- la première zone peut être dopée avec une concentration en éléments dopants actifs pouvant aller de 1.10¹⁶ à 1.10¹⁹ atomes/cm³;
- la deuxième zone peut être dopée avec une concentration en élément dopant pouvant aller de 1.10¹⁶ à 1.10¹⁹ atomes/cm³ ;
- la troisième zone peut être dopée avec une concentration en éléments dopants actifs pouvant aller de 1.10¹⁴ à 1.10¹⁶ atomes/cm³ ; et
- la quatrième zone peut être dopée avec une concentration en éléments dopants actifs pouvant aller de 1.10¹⁹ à 1.10²¹ atomes/cm³.

La première zone, la deuxième zone et la quatrième zone du substrat semi-conducteur de l'invention peuvent être de préférence des zones de forme allongée.

Plus particulièrement, l'axe longitudinal de la première zone est sensiblement parallèle à l'axe longitudinal de la deuxième zone, et l'axe longitudinal de la quatrième zone est sensiblement perpendiculaire à l'axe longitudinal de la première ou de la deuxième zone.

La dimension selon l'axe longitudinal de la quatrième zone allongée (i.e. la longueur de la quatrième zone) peut être optimisée afin que la jonction P-N définie par les première, deuxième et troisième zones puisse recevoir des tensions relativement élevées, tout en garantissant une troisième zone à géométrie compacte. Plus particulièrement la dimension à optimiser est la portion de la quatrième zone qui s'étend, dans son axe longitudinal, de la première zone vers la deuxième zone, cette portion étant d'ailleurs celle qui est en contact avec la troisième zone.

Le substrat semi-conducteur peut comprendre une face inférieure (ou face arrière) et une face supérieure (ou face avant), la face supérieure étant plus particulièrement une face sensiblement plane. De préférence, la face inférieure est aussi une face sensiblement plane, de sorte à avoir notamment la face inférieure parallèle à la face supérieure. La face supérieure est notamment la face sur laquelle sont positionnés des composants actifs, tels que par exemple des transistors.

Lorsque la quatrième zone est de forme allongée, elle est une zone dite « enfouie », d'axe longitudinal sensiblement parallèle à la face supérieure du substrat.

On entend par « zone enfouie » une zone disposée dans l'épaisseur du substrat telle qu'elle ne soit pas directement en contact physique avec les faces inférieure et supérieure du substrat. On peut parler de zone noyée au sein du substrat.

La jonction P-N peut être positionnée de sorte à ce que la première zone et la deuxième zone soient (directement) en contact avec la face supérieure du substrat. De ce fait, la première zone relie électriquement la quatrième zone à la face supérieure du substrat.

Le substrat semi-conducteur selon l'invention peut comprendre en outre :
- une cinquième zone dopée, distante de la première zone, ladite cinquième zone étant positionnée de sorte à avoir la première zone située entre la deuxième zone et la cinquième zone, et
- la première portion de la quatrième zone s'étendant en direction de la cinquième zone et jusqu'à la cinquième zone de manière à mettre en contact la quatrième zone avec la cinquième zone ; la première zone, la quatrième zone et la cinquième zone délimitant une sixième zone dopée.

Afin de former ledit puits et de délimiter la sixième zone, la cinquième zone est préférablement distincte de la première zone.

La cinquième zone peut être dopée selon le même type de dopage que celui de la quatrième zone dopée.

La sixième zone peut être dopée selon le même type de dopage que celui de la troisième zone dopée.

Plus particulièrement, la première zone, la quatrième zone et la cinquième zone peuvent avoir une concentration en élément dopant plus grande que celle de la sixième zone.

A titre d'exemple, en considérant que le matériau utilisé pour la fabrication du substrat semi-conducteur est du silicium :
- la cinquième zone peut être dopée avec une concentration en élément dopant pouvant aller de 1.10¹⁶ à 1.10¹⁹ atomes/cm³; et
- la sixième zone peut être dopée avec une concentration en élément dopant pouvant aller de 1.10¹⁴ à 1.10²¹ atomes/cm³.

Les types de dopage existants sont bien connus de l'homme du métier. Le premier type de dopage peut être un dopage de type N, et le second, un dopage de type P, ou vice-et-versa.

La première zone et la deuxième zone peuvent être des zones allongées, d'axe longitudinal sensiblement perpendiculaire à la face supérieure du substrat.

La cinquième zone peut également être une zone allongée, d'axe longitudinal sensiblement perpendiculaire à la face supérieure du substrat.

Plus particulièrement, lorsque la première zone, la quatrième zone et la cinquième zone sont des zones allongées selon leur axe longitudinal respectif, ces trois zones allongées forment la lettre « F » dans laquelle la barre verticale du « F » correspond à la quatrième zone, la barre horizontale supérieure du « F » correspond à la cinquième zone, et la barre horizontale inférieure du « F » correspond à la première zone

Le substrat semi-conducteur selon l'invention peut comprendre en outre un élément électriquement isolant (directement) en contact avec la face supérieure du substrat et situé entre la première zone et la deuxième zone. Cet élément électriquement isolant est de préférence (directement) en contact avec une portion de la première zone et une portion de la deuxième zone.

L'élément électriquement isolant peut être une isolation de surface par tranchée, bien connue sous les termes anglais « : *Shallow trench isolation »* (STI). Cette isolation de surface a pour fonction d'isoler électriquement la jonction P-N des composants actifs positionnés sur la face supérieure du substrat, tels que par exemple des transistors, ...etc

Les types de dopage existants sont bien connus de l'homme du métier. Le premier type de dopage peut être un dopage de type N, et le second, un dopage de type P, ou vice-et-versa.

En considérant que le matériau utilisé pour la fabrication du substrat semi-conducteur est du silicium, les éléments dopants du type N sont généralement choisis parmi les atomes ayant cinq électrons de valence, comme ceux de la colonne 15 (VA) du tableau périodique des éléments. A titre d'exemple, on peut citer le phosphore (P), l'arsenic (As) ou l'antimoine (Sb).

Les éléments dopants du type P sont généralement choisis parmi les atomes trivalents, comme ceux de la colonne 13 (IIIA) du tableau périodique des éléments. A titre d'exemple, on peut citer le bore (B), l'indium (In), etc....

Dans un mode de réalisation particulièrement préféré, la quatrième zone est dopée selon un dopage de type N. De ce fait, la première zone, avec laquelle la quatrième zone est en contact direct, est dopée selon un dopage de type N. La deuxième zone, avec laquelle la quatrième zone n'est pas directement en contact, est dopée selon un dopage de type P. Enfin, la troisième zone est également dopée selon un dopage de type P.

D'autres caractéristiques et avantages de la présente invention apparaîtront à la lumière de la description d'exemples non limitatifs de substrat semi-conducteur selon l'invention et de simulations électriques, faits en référence aux figures 1 à 5.
La figure 1 représente une vue partielle en coupe verticale d'un premier mode de réalisation d'un substrat semi-conducteur comprenant une jonction P-N.
La figure 2 représente une vue en coupe verticale d'un second mode de réalisation de la figure 1.
La figure 3 représente une vue en coupe verticale d'un substrat semi-conducteur comprenant une jonction P-N telle que représentée dans la figure 2, cette jonction P-N étant intégrée en partie dans une configuration de *« triple well* » .
La figure 4 représente une simulation électrique des lignes de densité de courant de claquage d'une jonction P-N selon l'art antérieur.
La figure 5 représente une simulation électrique des lignes de densité de courant de claquage d'une jonction P-N selon l'invention.

Pour des raisons de clarté, seuls les éléments essentiels pour la compréhension de l'invention ont été représentés de manière schématique, et ceci sans respect de l'échelle.

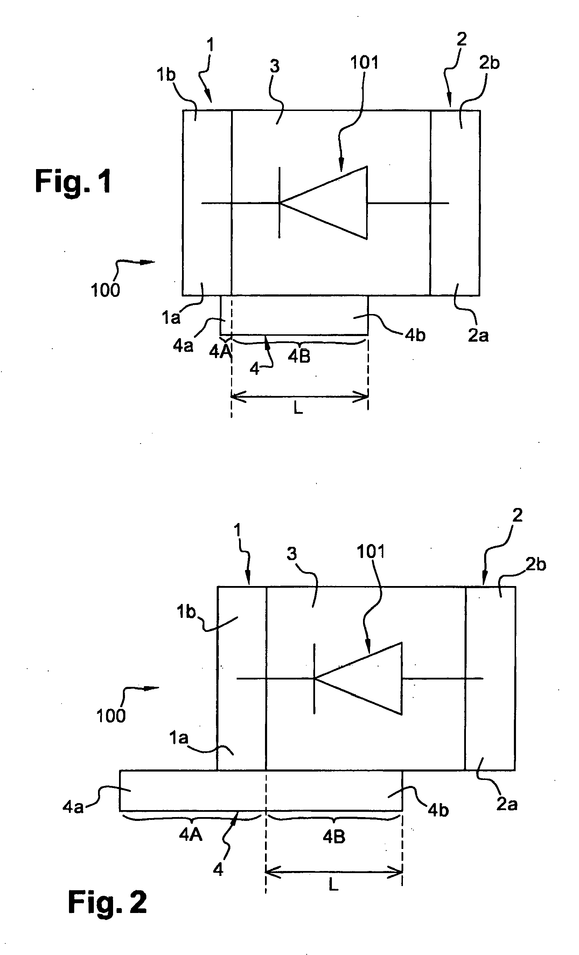

Les termes « inférieure », « supérieure », « verticale » et « horizontale » ne sont nullement limitatifs dans le cadre de la présente invention, et permettent notamment de faciliter la compréhension de l'invention au regard du positionnement du substrat tel que représenté sur les figures 1, 2 et 3 de l'invention.

Le substrat semi-conducteur 100 de la figure 1, du type silicium, comprend une jonction P-N 101 formée par :
- une première zone 1 de silicium dopé selon un dopage de type N, la concentration en élément dopant étant par exemple de 1.10¹⁶ à 1.10¹⁹ atomes/cm³,
- une deuxième zone 2 de silicium dopée selon un dopage de type P, la concentration en élément dopant étant par exemple de 1.10¹⁶ à 1.10¹⁹ atomes/cm³, et
- une troisième zone 3 de silicium dopée selon un dopage de type P, la concentration en élément dopant étant par exemple de 1.10¹³ à 1.10¹⁶ atomes/cm³.

La troisième zone 3 est intercalée entre la première zone 1 et la deuxième zone 2. La concentration en élément dopant de la troisième zone est inférieure à la concentration en élément dopant de la première zone 1 et de la deuxième zone 2.

La première zone 1 et la deuxième zone 2 sont des zones de forme allongée, de type sensiblement rectangulaire, sensiblement parallèles. Selon la figure 1, elles sont positionnées verticalement selon leur axe longitudinal.

La première zone allongée est terminée le long de son axe longitudinal par deux extrémités 1a,1b.

La deuxième zone allongée est terminée le long de son axe longitudinal par deux extrémités 2a,2b.

A une des extrémités 1a de la première zone 1 se trouve une quatrième zone 4 de silicium dopée selon un dopage de type N. Cette quatrième zone 4 a une concentration en élément dopant supérieure à la concentration la plus élevée en élément dopant de la première zone. A titre d'exemple, la concentration en élément dopant de la quatrième zone peut être de 1.10¹⁹ à 1.10²¹ atomes/cm³.

La quatrième zone est de forme allongée, de type sensiblement rectangulaire, et est sensiblement perpendiculaire aux première et deuxième zones allongées. Elle comprend une première portion 4A en contact avec la première zone 1, et une deuxième portion 4B, en contact avec la troisième zone 3, s'étendant en direction de la deuxième zone 2 sans la toucher. En outre, cette quatrième zone 4 est terminée le long de son axe longitudinal par deux extrémités 4a,4b.

Plus particulièrement, dans le mode de réalisation représenté sur la figure 1, une de ses extrémités 4a est directement en contact avec la première zone 1, ou plus particulièrement avec une des extrémités 1a de la première zone. En outre, la quatrième zone 4 est également directement en contact avec la troisième zone 3, et son extrémité 4b s'étend vers la deuxième zone sans être en contact avec cette dernière.

Dans le mode de réalisation représenté sur la figure 2, l'extrémité 4a de la quatrième zone s'étend dans la direction opposée à l'extrémité 4b. Ainsi, l'extrémité 1a de la première zone, directement en contact avec la quatrième zone, est située à distance des deux extrémités 4a,4b de la quatrième zone.

Dans la figure 1 ou 2, l'allongement L de la portion de la quatrième zone (deuxième portion 4B) s'étendant de la première zone 1 vers la deuxième zone 2 peut être optimisée afin que la jonction P-N puisse recevoir des tensions relativement importantes, tout en garantissant une miniaturisation de la structure.

L'optimisation dudit allongement L peut être facilement réalisée par des techniques bien connues de l'homme du métier, en particulier par modélisation et résolution numérique (TCAD). De nombreux logiciels du commerce sont disponibles pour faciliter cette optimisation.

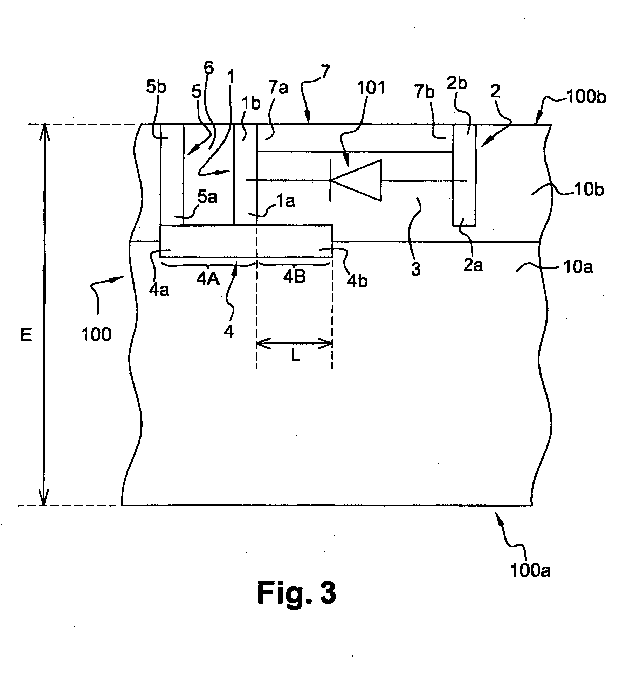

La figure 3 représente un mode de réalisation particulier d'un substrat semi-conducteur comprenant une jonction P-N telle que définie dans la figure 2, cette jonction P-N étant intégrée en partie dans une configuration de *« triple well* » .

Le substrat 100 de silicium a été réalisé en formant par épitaxie, sur une première couche 10a de silicium dopé P, une seconde couche 10b de silicium dopé P. Dans cet exemple, l'épaisseur de la couche 10a peut être comprise entre 500 et 800 µm, et l'épaisseur 10b peut être comprise entre 1 et 10 µm. Le substrat comprend ainsi une face inférieure 100a (ou face arrière) formée par ladite première couche 10a, et une face supérieure 100b (ou face avant) formée par ladite seconde couche 10b. Selon la figure 3, la face inférieure 100a et la face supérieure 100b du substrat sont toutes deux des faces sensiblement planes et horizontales.

La face supérieure du substrat est destinée à comporter des composants actifs tels que des transistors, ...etc.

L'épaisseur E du substrat 100 est ainsi définie dans la figure 3 comme étant l'ensemble des épaisseurs de la première et de la seconde couche de silicium.

Le substrat comprend en outre la jonction P-N telle que décrite dans la figure 2.

La quatrième zone 4 allongée de la jonction P-N est une couche dite « enfouie », noyée au sein du substrat 100, pouvant en partie diffuser dans la première et dans la seconde couche de silicium 10a, 10b.

La première et la deuxième zones allongées s'étendent dans l'épaisseur E du substrat et ont leur axe longitudinal sensiblement perpendiculaires à la face supérieure 100b du substrat.

L'axe longitudinal de la quatrième zone est sensiblement parallèle à la face supérieure 100b du substrat.

La première zone 1 et la deuxième zone 2 sont en contact avec la face supérieure du substrat. Plus particulièrement, l'extrémité 1b de la première zone est directement en contact avec la face supérieure du substrat, et l'extrémité 2b de la deuxième zone est directement en contact avec la face supérieure du substrat.

De ce fait, la première zone 1 relie la quatrième zone 4 à la face supérieure du substrat.

Le substrat semi-conducteur 100 comprend en outre une cinquième zone 5 dopée, distante de la première zone, ladite cinquième zone étant positionnée de sorte à avoir la première zone 1 située entre la deuxième zone 2 et ladite cinquième zone 5. Cette cinquième zone 5 est dopée selon le même type de dopage que celui de la quatrième zone 4 dopée, à savoir le dopage est de type N.

Cette cinquième zone 5 est une zone de forme allongée, de type sensiblement rectangulaire, qui est terminée le long de son axe longitudinal par deux extrémités 5a,5b. Elle est sensiblement perpendiculaire à la face supérieure 100b du substrat.

La cinquième zone 5 est en contact avec la face supérieure du substrat. Plus particulièrement, l'extrémité 5b de la cinquième zone est directement en contact avec la face supérieure du substrat.

En outre, la quatrième zone de forme allongée s'étend jusqu'à la cinquième zone de manière à mettre en contact l'extrémité 4a de la quatrième zone avec l'extrémité 5a de la cinquième zone.

Ainsi, la première zone 1 et la cinquième zone 5 relient la quatrième zone 4 à la face supérieure du substrat.

De ce fait, la première zone (i.e. puits dopé N), la quatrième zone (i.e. couche enfouie dopée N) et la cinquième zone (i.e. puits dopé N) délimitent un puits isolé de type P (i.e. *« triple well »* dopé P) correspondant à une sixième zone 6 dopée, ladite sixième zone étant dopée selon le même type de dopage que celui de la troisième zone 3 dopée, à savoir selon un dopage de type P.

Un puits isolé de type N (i.e. *« triple well »* dopé N) pourrait bien entendu également être considéré dans le cas où la première zone, la quatrième zone et la cinquième zone seraient des zones dopées selon un dopage de type P.

En référence à la figure 3, la première zone 1, la quatrième zone 4 (i.e. couche enfouie) et la cinquième zone 5 forme la lettre « F » dans laquelle la barre verticale du « F » correspond à la quatrième zone, la barre horizontale supérieure du « F » correspond à la cinquième zone, et la barre horizontale inférieure du « F » correspond à la première zone.

Les concentrations en éléments dopants des cinquième et sixième zones peuvent être les suivantes :
- pour la cinquième zone, la concentration en élément dopant peut être du même ordre que celle de la première zone, et
- pour la sixième zone, la concentration en élément dopant peut être de 1.10¹⁴ à 1.10²¹ atomes/cm³.

Le substrat semi-conducteur selon l'invention peut comprendre en outre un élément électriquement isolant 7 en contact avec la face supérieure 100b du substrat et situé entre la première zone 1 et la deuxième zone 2.

Sur la figure 3, cet élément électriquement isolant est une isolation de surface, bien connue sous l'anglicisme « *Shallow Trench Isolation »* (STI).

On peut citer comme matériau électriquement isolant constitutif de ladite isolation de surface 7 de l'oxyde de silicium (SiO₂).

Dans la figure 3, cette isolation de surface 7 est représentée par un élément allongé, d'axe longitudinal sensiblement parallèle à celui du substrat, et terminé le long de son axe longitudinal par deux extrémités 7a,7b.

L'extrémité 7a et l'extrémité 7b de l'isolation de surface 7 sont respectivement en contact avec l'extrémité 1b de la première zone, et avec l'extrémité 2b de la deuxième zone.

Ainsi, l'ensemble formé par la première zone, l'isolation de surface (STI) et la deuxième zone formant un « U » à l'envers, dont la barre horizontale correspond à l'isolation de surface 7, et les deux barres verticales correspondent aux première et deuxième zones 1 et 2.

La portion de la quatrième zone 4, en contact avec la troisième zone, se retrouve en partie en face de l'isolation de surface, et séparée de l'isolation de surface par la troisième zone 3.

Bien entendu, les dopages de type P mentionnés dans les descriptifs des figures 1, 2 et 3, peuvent être des dopages de type N, et les dopages de type N mentionnés dans le descriptif desdites figures peuvent être des dopages de type P.

Le substrat semi-conducteur comprenant la jonction P-N selon l'invention peut être réalisée par des techniques bien connues de l'homme du métier.

A titre d'exemple, le substrat semi-conducteur représenté sur la figure 3 peut être fabriqué comme suit.

La quatrième zone 4 est tout d'abord formée par application d'un masque de résine définissant ladite quatrième zone dans la première couche 10a de silicium dopé P.

L'élément dopant de type N de la quatrième zone est ensuite implanté en surface dans la quatrième zone, la résine étant ensuite éliminée.

Afin d'activer l'élément dopant de type N de la quatrième zone, le substrat est chauffée à une température de plus de 1000°C.

Puis, une épitaxie bore à 1.10¹⁵ atomes/cm³ est réalisée à la surface du substrat, au dessus de la quatrième zone 4 et de la première couche 10a.

Une fois l'épitaxie terminée pour former la seconde couche 10b, les puits de type N sont formés par application d'un masque pour définir la première zone (1) et la cinquième zone (5). Puis, l'élément dopant de type N est ensuite implanté en surface et en profondeur dans les puits 1 et 5. Enfin, la résine est éliminée.

Un puits de type P est également formé par application d'un masque pour définir la deuxième zone (2). Puis, l'élément dopant de type P est ensuite implanté en surface et en profondeur dans le puits 2. Enfin, la résine est éliminée.

Afin d'activer l'élément dopant de type N de la première zone et l'élément dopant P de la deuxième zone, le substrat est chauffé à une température de plus de 1000°C.

Le niveau de dopage de la troisième zone (3) est déterminé par la nature de l'épitaxie de la seconde couche 10b.

Afin de montrer l'avantage du substrat semi-conducteur de l'invention, des essais de simulation ont été réalisés.

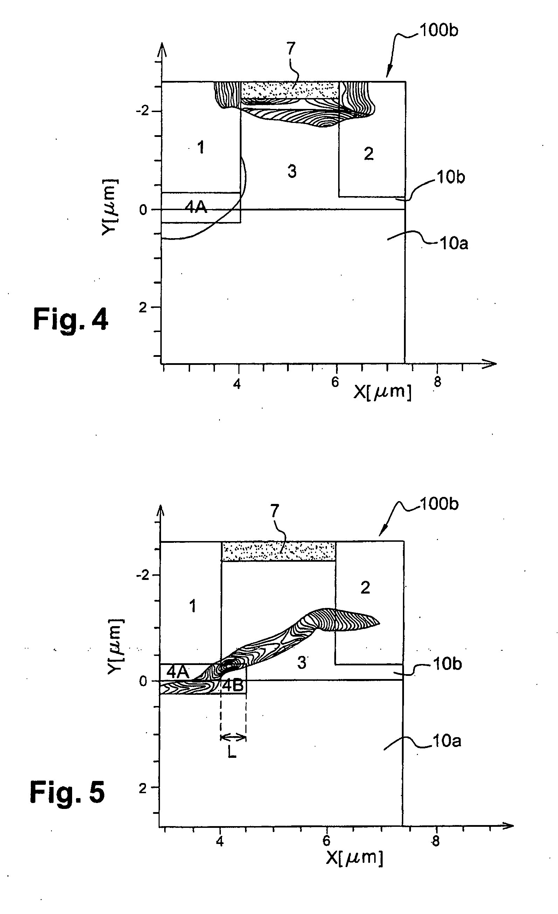

Ces essais permettent de comparer le comportement électrique entre une jonction P-N classique (Figure 4) et une jonction P-N selon l'invention (Figure 5).

La jonction P-N de la figure 5 correspond à celles représentées sur la figure 1, 2 ou 3, à savoir :
- la première zone 1 correspond à un puits dopé N (1.10¹⁶ à 1.10¹⁹ atomes/cm³),
- la deuxième zone 2 correspond à un puits dopé P (1.10¹⁶ à 1.10¹⁹ atomes/cm³),
- la troisième zone 3 (ou la seconde couche 10b) correspond a une zone faiblement dopée P (dopage épitaxie 1.10¹⁵ atomes/cm³),
- la quatrième zone 4 correspond a une zone enterrée (« *buried layer* ») dopée N (1.10¹⁹ à 1.10²¹ atomes/cm³).

La première couche 10a correspond à une zone faiblement dopée P (1.10¹⁵ atomes/cm³).

L'espacement entre la première zone 1 et la deuxième zone 2, défini par la troisième zone, est de 2 µm. La quatrième zone est enterrée à une distance de 2,5 µm de la face supérieure du substrat 100b.

L'extension 4B de la quatrième zone enterrée s'étend sur une longueur L de 0,5 µm de la première zone 1 en direction de la deuxième zone 2, tout en étant en contact avec la troisième zone 3, sans être en contact avec la deuxième zone 2.

La jonction P-N de la figure 4 est en tout point identique à celle décrite dans la figure 5, exceptée qu'elle ne comprend pas l'extension 4B de la quatrième zone enterrée.

Les simulations des lignes de densité de courant sont représentées sur les figures 4 et 5 et ont été effectuées à l'aide du logiciel Sentaurus (Synopsis) v2009.06, selon le modèle électrique VanOverStraten.

Schématiquement, la modélisation électrique réalisée par ce logiciel consiste à simuler une montée progressive de la tension aux bornes de la jonction P-N et de déterminer la valeur et la répartition du courant résultant.

Au démarrage de ce processus itératif et donc pour des tensions faibles à modérées, la jonction P-N est polarisée en inverse et reste dans un régime diodique d'isolation. Lorsque la tension simulée devient plus élevée et approche la tension de claquage, un courant d avalanche important se crée.

On a défini arbitrairement dans ces simulations la valeur de la tension de claquage comme étant la tension a partir de laquelle le courant produit devient supérieur à un courant total seuil de 1 microampère.

Les figures 4 et 5 montrent la vue topographique des densités de courant issu du logiciel au moment du claquage (courbes d'iso-contours en ampères/cm²) et permet d'évaluer ainsi la localisation du courant d'avalanche qui est produit.

On observe facilement que le courant généré au moment du claquage est proche de la face supérieure 100b du substrat semi-conducteur sur la figure 4, tandis qu'il est éloigné de la face supérieur 100b dudit substrat, ou en d'autres termes enterré, sur la figure 5.

En outre, la jonction P-N représentée sur la figure 4 est isolée correctement (i.e. sans claquage) de 0V jusqu'à l'application d'une tension de 34,8 V. La jonction P-N représentée sur la figure 5 est isolée correctement (i.e. sans claquage) de 0V jusqu'à l'application d'une tension de 38 V.

Par conséquent, la présente invention améliore de 9% la tenue en isolation électrique de la jonction P-N grâce à la présence de la portion 4B de la quatrième zone.

## Revendications

1. Substrat semi-conducteur (100) comprenant des zones dopées formant une jonction P-N (101), les zones dopées comprenant:
- une première zone (1) dopée selon un premier type de dopage,
- une deuxième zone (2) dopée selon un deuxième type de dopage,
- une troisième zone (3) dopée selon le deuxième type de dopage, la troisième zone étant située entre la première zone et la deuxième zone, la concentration en élément dopant de la troisième zone étant inférieure à la concentration en élément dopant de la première zone et inférieure à la concentration en élément dopant de la deuxième zone,
- une face inférieure (100a), et
- une face supérieure (100b), la première zone (1) et la deuxième zone (2) étant en contact avec la face supérieure (100b) du substrat,
la jonction P-N (101) comprenant en outre une quatrième zone (4) dopée comportant :
- une première portion (4A) en contact avec la première zone, et
- une deuxième portion (4B) en contact avec la troisième zone (3), ladite deuxième portion (4B) s'étendant en direction de la deuxième zone (2), et n'étant pas en contact avec la deuxième zone (2),
ladite quatrième zone (4) étant dopée selon le même type de dopage que celui de la première zone, le substrat étant **caractérisé en ce que** la concentration en élément dopant de la quatrième zone (4) est supérieure à la concentration la plus élevée en élément dopant de la première zone (1).

2. Substrat semi-conducteur selon la revendication 1, **caractérisée en ce que** la concentration en élément dopant de la troisième zone (3) est inférieure à la concentration la plus basse en élément dopant de la première zone (1), de la deuxième zone (2) et de la quatrième zone (4).

3. Substrat semi-conducteur selon l'une quelconque des revendications précédentes, **caractérisée en ce que** la première zone (1), la deuxième zone (2) et la quatrième zone (4) sont des zones de forme allongée, l'axe longitudinal de la première zone (1) étant sensiblement parallèle à l'axe longitudinal de la deuxième zone (2), et l'axe longitudinal de la quatrième zone (4) étant sensiblement perpendiculaire à l'axe longitudinal de la première ou de la deuxième zone.

4. Substrat semi-conducteur selon l'une quelconque des revendications précédentes, **caractérisé en ce que** la face supérieure (100b) est une face sensiblement plane.

5. Substrat semi-conducteur selon la revendication 3, **caractérisé en ce que** la quatrième zone (4) est une zone dite « enfouie », d'axe longitudinal sensiblement parallèle à la face supérieure du substrat.

6. Substrat semi-conducteur selon l'une quelconque des revendications 1 à 5, **caractérisé en ce qu'**il comprend en outre :
- une cinquième zone (5) dopée, distante de la première zone, ladite cinquième zone étant positionnée de sorte à avoir la première zone (1) située entre la deuxième zone (2) et la cinquième zone (5), et
- la première portion (4A) de la quatrième zone (4) s'étendant en direction de la cinquième zone (5) et jusqu'à la cinquième zone (5) de manière à mettre en contact la quatrième zone (4) avec la cinquième zone (5) ; la première zone, la quatrième zone et la cinquième zone délimitant une sixième zone (6) dopée.

7. Substrat semi-conducteur selon la revendication 6, **caractérisé en ce que** la cinquième zone (5) est en contact avec la face supérieure (100b) du substrat.

8. Substrat semi-conducteur selon la revendication 6 ou 7, **caractérisé en ce que** la cinquième zone (5) est dopée selon le même type de dopage que celui de la quatrième zone (4) dopée.

9. Substrat semi-conducteur selon l'une quelconque des revendications 6 à 8, **caractérisé en ce que** la sixième zone (6) est dopée selon le même type de dopage que celui de la troisième zone (3) dopée.

10. Substrat semi-conducteur selon l'une quelconque des revendications 5 à 8, **caractérisé en ce que** la première zone (1) et la deuxième zone (2) sont des zones allongées, d'axe longitudinal sensiblement perpendiculaire à la face supérieure du substrat.

11. Substrat semi-conducteur selon l'une quelconque des revendications 6 à 10, **caractérisé en ce que** la cinquième zone (5) est une zone allongée, d'axe longitudinal sensiblement perpendiculaire à la face supérieure du substrat.

12. Substrat semi-conducteur selon l'une quelconque des revendications 6 à 11, **caractérisé en ce qu'**il comprend en outre un élément électriquement isolant (7) en contact avec la face supérieure (100b) du substrat et situé entre la première zone (1) et la deuxième zone (2).

13. Substrat semi-conducteur selon l'une quelconque des revendications précédentes, **caractérisé en ce que** le premier type de dopage est de type N (ou P), et le second type de dopage est de type P (ou N).

## Patentansprüche

1. Halbleitersubstrat (100), das einen p-n-Übergang (101) ausbildende dotierte Gebiete umfasst, wobei die dotierten Gebiete umfassen:
- ein erstes, gemäß einem ersten Dotierungstyp dotiertes Gebiet (1),
- ein zweites, gemäß einem zweiten Dotierungstyp dotiertes Gebiet (2),
- ein drittes, gemäß dem zweiten Dotierungstyp dotiertes Gebiet (3), wobei sich das dritte Gebiet zwischen dem ersten Gebiet und dem zweiten Gebiet befindet, wobei die Dotierungselementkonzentration des dritten Gebiets niedriger ist als die Dotierungselementkonzentration des ersten Gebiets und niedriger als die Dotierungselementkonzentration des zweiten Gebiets,
- eine Unterseite (100a), und
- eine Oberseite (100b), wobei das erste Gebiet (1) und das zweite Gebiet (2) mit der Oberseite (100b) des Substrats im Kontakt sind,
wobei der p-n-Übergang (101) ferner ein viertes dotiertes Gebiet (4) umfasst, das aufweist:
- einen ersten Abschnitt (4A) im Kontakt mit dem ersten Gebiet, und
- einen zweiten Abschnitt (4B) im Kontakt mit dem dritten Gebiet (3), wobei sich der zweite Abschnitt (4B) in Richtung des zweiten Gebiets (2) erstreckt und nicht mit dem zweiten Gebiet (2) im Kontakt ist,
wobei das vierte Gebiet (4) gemäß demselben Dotierungstyp wie das erste Gebiet dotiert ist, wobei das Substrat **dadurch gekennzeichnet ist, dass** die Dotierungselementkonzentration des vierten Gebiets (4) höher ist als die höchste Dotierungselementkonzentration des ersten Gebiets (1).

2. Halbleitersubstrat nach Anspruch 1, **dadurch gekennzeichnet, dass** die Dotierungselementkonzentration des dritten Gebiets (3) niedriger ist als die niedrigste Dotierungselementkonzentration des ersten Gebiets (1), des zweiten Gebiets (2) und des vierten Gebiets (4).

3. Halbleitersubstrat nach einem der vorangehenden Ansprüche, **dadurch gekennzeichnet, dass** das erste Gebiet (1), das zweite Gebiet (2) und das vierte Gebiet (4) länglich geformte Gebiete sind, wobei die Längsachse des ersten Gebiets (1) etwa parallel zur Längsachse des zweiten Gebiets (2) ist und die Längsachse des vierten Gebiets (4) etwa lotrecht zur Längsachse des ersten oder des zweiten Gebiets ist.

4. Halbleitersubstrat nach einem der vorangehenden Ansprüche, **dadurch gekennzeichnet, dass** die Oberseite (100b) eine etwa ebene Seite ist.

5. Halbleitersubstrat nach Anspruch 3, **dadurch gekennzeichnet, dass** das vierte Gebiet (4) ein sogenanntes "vergrabenes" Gebiet mit einer zur Oberseite des Substrats etwa parallelen Längsachse ist.

6. Halbleitersubstrat nach einem der Ansprüche 1 bis 5, **dadurch gekennzeichnet, dass** es ferner umfasst:
- ein fünftes dotiertes, vom ersten Gebiet beabstandetes Gebiet (5), wobei das fünfte Gebiet derart positioniert ist, dass sich das erste Gebiet (1) zwischen dem zweiten Gebiet (2) und dem fünften Gebiet (5) befindet, und
- wobei sich der erste Abschnitt (4A) des vierten Gebiets (4) in Richtung des fünften Gebiets (5) und bis zum fünften Gebiet (5) derart erstreckt, dass das vierte Gebiet (4) mit dem fünften Gebiet (5) in Kontakt versetzt wird; wobei das erste Gebiet, das vierte Gebiet und das fünfte Gebiet ein sechstes dotiertes Gebiet (6) begrenzen.

7. Halbleitersubstrat nach Anspruch 6, **dadurch gekennzeichnet, dass** das fünfte Gebiet (5) mit der Oberseite (100b) des Substrats im Kontakt ist.

8. Halbleitersubstrat nach Anspruch 6 oder 7, **dadurch gekennzeichnet, dass** das fünfte Gebiet (5) gemäß demselben Dotierungstyp wie das vierte dotierte Gebiet (4) dotiert ist.

9. Halbleitersubstrat nach einem der Ansprüche 6 bis 8, **dadurch gekennzeichnet, dass** das sechste Gebiet (6) gemäß demselben Dotierungstyp wie das dritte dotierte Gebiet (3) dotiert ist.

10. Halbleitersubstrat nach einem der Ansprüche 5 bis 8, **dadurch gekennzeichnet, dass** das erste Gebiet (1) und das zweite Gebiet (2) längliche Gebiete mit einer zur Oberseite des Substrats etwa lotrechten Längsachse sind.

11. Halbleitersubstrat nach einem der Ansprüche 6 bis 10, **dadurch gekennzeichnet, dass** das fünfte Gebiet (5) ein längliches Gebiet mit einer zur Oberseite des Substrats etwa lotrechten Längsachse ist.

12. Halbleitersubstrat nach einem der Ansprüche 6 bis 11, **dadurch gekennzeichnet, dass** es ferner ein elektrisch isolierendes Element (7) im Kontakt mit der Oberseite (100b) des Substrats umfasst, das sich zwischen dem ersten Gebiet (1) und dem zweiten Gebiet (2) befindet.

13. Halbleitersubstrat nach einem der vorangehenden Ansprüche, **dadurch gekennzeichnet, dass** der erste Dotierungstyp von Typ n (oder p) und der zweite Dotierungstyp vom Typ p (oder n) ist.

## Claims

1. A semiconductor substrate (100) comprising doped zones forming a P-N junction (101), the doped zones comprising:
• a first zone (1) doped with a first type of doping;
• a second zone (2) doped with a second type of doping; and
• a third zone (3) doped with the second type of doping, the third zone being located between the first zone and the second zone, the concentration of doping element of the third zone being lower than the concentration of doping element of the first zone and lower than the concentration of doping element of the second zone;
• a bottom face (100a), and
• a top face (100b), the first zone (1) and the second zone (2) being in contact with the top face (100b) of the substrate,
the P-N junction (101) further comprising a fourth doped zone (4) comprising:
• a first portion (4A) in contact with the first zone; and
• a second portion (4B) in contact with the third zone (3), said second portion (4B) extending in the direction of the second zone (2), and not being in contact with the second zone (2);
said fourth zone (4) being doped with the same type of doping as that of the first zone, the substrate being **characterized in that** the concentration of doping element of the fourth zone (4) is greater than the highest concentration of doping element of the first zone (1).

2. A semiconductor substrate according to claim 1, **characterized in that** the concentration of doping element of the third zone (3) is lower than the lowest concentration of doping element of the first zone (1), of the second zone (2), and of the fourth zone (4).

3. A semiconductor substrate according to any preceding claim, **characterized in that** the first zone (1), the second zone (2) and the fourth zone (4) are zones with an elongate shape, the longitudinal axis of the first zone (1) being substantially parallel to the longitudinal axis of the second zone (2), and the longitudinal axis of the fourth zone (4) being substantially perpendicular to the longitudinal axis of the first or the second zone.

4. A semiconductor substrate according to any preceding claim, **characterized in that** the top face (100b)is a substantially planar face.

5. A semiconductor substrate according to claim 3, **characterized in that** the fourth zone (4) is a "buried" zone with a longitudinal axis that is substantially parallel to the top face of the substrate.

6. A semiconductor substrate according to any one of claims 1 to 5, **characterized in that** it further comprises:
• a fifth doped zone (5), distant from the first zone, said fifth zone being positioned such that the first zone (1) is situated between the second zone (2) and the fifth zone (5); and
• the first portion (4A) of the fourth zone (4) extends in the direction of the fifth zone (5) and up to the fifth zone (5) so as to bring the fourth zone (4) into contact with the fifth zone (5); the first zone, the fourth zone and the fifth zone define a sixth doped zone (6).

7. A semiconductor substrate according to claim 6, **characterized in that** the fifth zone (5) is in contact with the top face (100b) of the substrate.

8. A semiconductor substrate according to claim 6 or claim 7, **characterized in that** the fifth zone (5) has the same doping type as that of the fourth doped zone (4).

9. A semiconductor substrate according to any one of claims 6 to 8, **characterized in that** the sixth zone (6) has the same type of doping as that of the third doped zone (3).

10. A semiconductor substrate according to any one of claims 5 to 8, **characterized in that** the first zone (1) and the second zone (2) are elongate zones with a longitudinal axis substantially perpendicular to the top face of the substrate.

11. A semiconductor substrate according to any one of claims 6 to 10, **characterized in that** the fifth zone (5) is an elongate zone with a longitudinal axis that is substantially perpendicular to the top face of the substrate.

12. A semiconductor substrate according to any one of claims 6 to 11, **characterized in that** it further comprises an electrically isolating element (7) in contact with the top face (100b) of the substrate and located between the first zone (1) and the second zone (2).

13. A semiconductor substrate according to any preceding claim, **characterized in that** the first type of doping is N (or P) type and the second type of doping is P (or N) type.
